# EUROPÄISCHE PATENTSCHRIFT

(11) **EP 0 415 039 B1**
(45) Veröffentlichungstag und Bekanntmachung des Hinweises auf die Patenterteilung: **08.12.1993**
(21) Anmeldenummer: 90113190.4
(22) Anmeldetag: 11.07.1990
(51) Int. Cl.: B60T 8/88

(54) **Elektronische Schaltung zur Überwachung eines Endverstärkers und seiner Last**
Electronic circuit for monitoring a final amplifier and its load
Circuit électronique pour surveiller un amplificateur de sortie et sa charge

(30) Priorität: 30.08.1989 DE 3928651
(43) Veröffentlichungstag der Anmeldung: 06.03.1991
(73) Patentinhaber: WABCO Vermögensverwaltungs-GmbH, D-30432 Hannover (DE)
(72) Erfinder: Holst, Hans, D-3000 Hannover 91 (DE); Ruhnau, Gerhard, D-3057 Neustadt 1 (DE); Pape, Klaus, D-3000 Hannover 91 (DE)
(74) Vertreter: Schrödter, Manfred, Dipl.-Ing.

(56) Entgegenhaltungen:
- EP-A- 0 189 713
- DE-A- 2 631 569
- GB-A- 925 027
- US-A- 3 924 159

## Beschreibung

Die Erfindung bezieht sich auf eine elektronische Schaltung zur Überwachung eines Endverstärkers und seiner Last, insbesondere in einem Antiblockiersystem für Fahrzeuge, gemäß dem Oberbegriff des Patentanspruchs 1.

Antiblockiersysteme in Fahrzeugen haben besonders hohe Anforderungen in bezug auf Funktionssicherheit zu erfüllen. Alle evtl. auftretenden elektrischen oder mechanischen Fehler müssen möglichst schnell erkannt werden. Die Elektronik muß dann so reagieren, daß das System, z.B. durch eine Teilabschaltung, in einen sicheren Zustand zurückgeführt wird. Im Extremfall muß der Blockierschutz abgeschaltet werden, so daß dann das Fahrzeug nur noch in konventioneller Weise abgebremst werden kann.

Es sind bereits Prüfschaltungen für die Elektronik von Antiblockiersystemen bekannt. So werden z. B. in der DE-A-26 31 569 Prüfimpulse in den Regelkanal eingespeist, hinter dem Endverstärker abgegriffen und auf Richtigkeit untersucht. Die Impulse sind dabei von so kurzer Dauer, daß das nachgeschaltete Magnetventil nicht mechanisch schaltet.

Ein besonders zu überwachendes Teilsystem eines Antiblockiersystems ist dessen Endstufe. Diese wird bekanntlich von einer Logikschaltung oder einem Mikrocomputer entsprechend den Radgeschwindigkeiten bzw. -beschleunigungen des überwachten Rades angesteuert.

Der Leistungstransistor der Endstufe steuert dabei die Stromversorgung eines Magnetventils zur Steuerung der entsprechenden Radbremse.

Hierbei können die folgenden Fehler auftreten. Es kann die Wicklung des Magnetventils (Last) eine Unterbrechung, einen Kurzschluß, oder einen unzulässigen Widerstandswert aufweisen. Dieselben Fehlermöglichkeiten gelten auch für das Verbindungskabel zwischen Endstufe und Last.

Weiter kann auch der Endtransistor selbst eine Unterbrechung oder einen Kurzschluß aufweisen.

Zur Sensierung der erwähnten Fehler ist es denkbar, in die Verbindungsleitung zur Last einen niederohmigen Strom-Meßwiderstand einzufügen. Hiermit kann man einen zu hohen oder zu kleinen Stromwert erkennen. Bei den in einem Antiblockiersystem zu schaltenden hohen Strömen wäre jedoch der Spannungsabfall am Meßwiderstand unzulässig hoch.

Es ist weiter denkbar, einen Fehler indirekt über die in der Regel im System vorhandene Einschaltdauer-Überwachung des Magnetventils zu erkennen. Dies ist jedoch nicht in allen Fällen möglich. So kann z.B. beim Herunterschalten auf glatter Straße (Eis oder Schnee) ein Rad längere Zeit blockieren, ohne das gebremst wird. In diesem Fall würde dann ein Fehler angezeigt, obwohl in Wirklichkeit die Schaltung korrekt arbeitet.

Der Erfindung liegt die Aufgabe zugrunde, eine Schaltung anzugeben, mit welcher die o.g. Fehler, insbesondere ein Kurzschluß in der Endstufe, oder eine Unterbrechung in dem Verbindungskabel oder der Last einer elektronischen Schaltung, insbesondere eines Antiblockiersystems, zuverlässig erkannt und unterschieden werden können.

Eine Unterscheidungsmöglichkeit ist besonders bei einem Antiblockiersystem für Fahrzeuge wichtig. Hier muß nämlich bei einem Fehler des Endtransistors, insbesondere einem Kurzschluß, das System sofort abgeschaltet werden, da bei der in diesem Fall auftretenden ständigen Bestromung des Regelventils das betreffende Rad nicht mehr bremsbar wäre (kritischer Fall).

Hingegen braucht bei einer Unterbrechung in der Last das System nicht abgeschaltet zu werden, da in diesem Fall lediglich das betroffene Rad blockiert, also weiter zur Bremsung beiträgt (unkritischer Fall).

Die obengestellte Aufgabe wird durch die im Patentanspruch 1 enthaltende Erfindung gelöst. Die Unteransprüche enthalten zweckmäßige Weiterbildungen der Erfindung.

Die Erfindung wird im folgenden anhand einer Zeichnung näher erläutert. Dabei zeigt die
- **Fig.1**: ein Blockschaltbild eines Antiblockiersystems gemäß dem Stand der Technik,
- **Fig.2**: eine erste Ausführung der erfindungsgemäßen Überwachungsschaltung,
- **Fig.3**: eine zweite Ausführung der erfindungsgemäßen Überwachungsschaltung, und
- **Fig.4** **und** **5**: ein Schaltbild des elektronischen Umschalters.

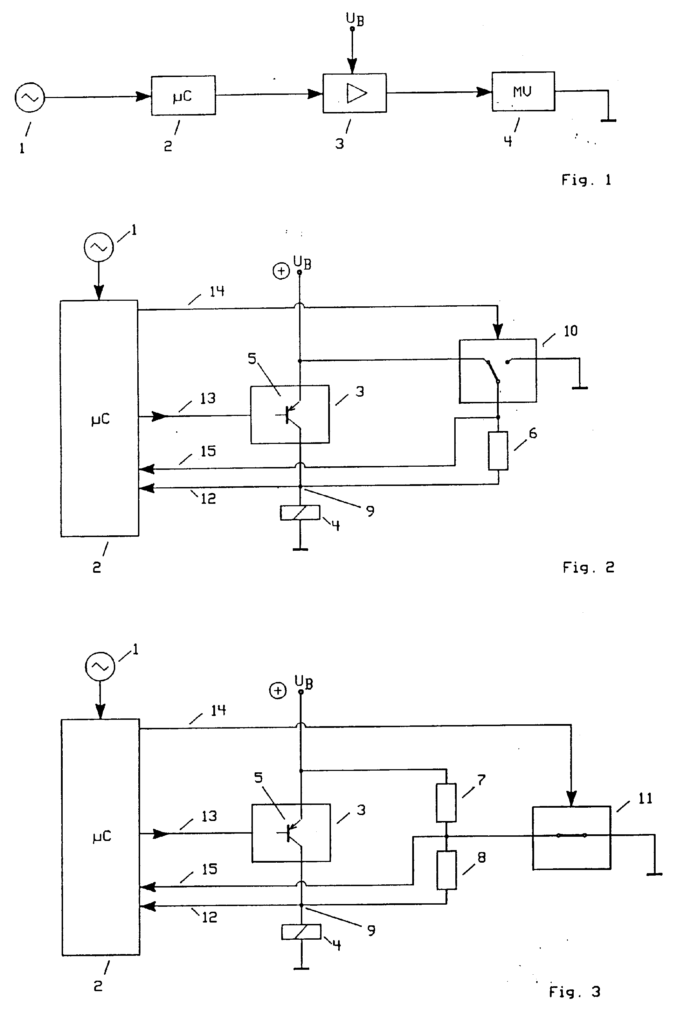

In der Fig.1 ist als Blockschaltbild ein bekanntes Fahrzeug-Antiblockiersystem dargestellt. An diesem soll die erfindungsgemäße Überwachungsschaltung näher erläutert werden. Die Schaltung kann aber selbstverständlich auch bei anderen Elektroniken mit Endverstärker angewendet werden.

Ein am zu regelnden Rad angeordneter Drehzahlgeber (1) erzeugt der Radgeschwindigkeit proportionale Signale, die nach einer Aufbereitung (nicht dargestellt) einen Mikrocomputer (2) zugeführt werden. Der Mikrocomputer (2) enthält ein Programm, nach welchem aus den Signalen des Drehzahlgebers (1) entsprechende Ansteuersignale für eine Last (4) gebildet werden. Die Last (4) ist hier ein Magnetventil und liegt in der Druckleitung des Bremszylinders des zugehörigen zu regelnden Rades (nicht dargestellt). Durch eine entsprechende Modulation des Bremsdruckes wird so in bekannter Weise ein Blockieren des Rades verhindert und das Rad stets im optimalen Schlupfbereich von ca. 20 % gehalten.

Zwischen dem Mikrocomputer (2) und dem Magnetventil (4) liegt zur Verstärkung der Computerausgangssignale ein Endverstärker (3). Dieser besteht aus mehreren Transistoren, von denen der Endtransistor (5) in den Figuren 2 und 3 dargestellt ist. Für den Mikrocomputer (2) reicht eine stabilisierte Betriebsspannung (U_{stab}) aus, während für den Endverstärker (3) wegen der vielfach höheren Stromaufnahme ein direkter Anschluß an die Fahrzeugbatterie (U_{B}) vorgesehen ist. Aus diesem Grund ist für den Mikrocomputer (2) nicht direkt erkennbar, ob z.B. im Fall eines Kurzschlusses der Last die Batteriespannung U_{B} heruntergezogen wird.

In der Fig.2 ist das Blockschaltbild aus der Fig.1 näher dargestellt, ergänzt um die erfindungsgemäße Anordnung zur Überwachung des Endverstärkers (3). Gleiche Bezugsziffern bedeuten gleiche Bauteile. Mit (5) ist der Leistungstransistor des Endverstärkers (3) bezeichnet. Dieser wird vom Mikrocomputer (2) entsprechend der Radbewegung über eine Leitung (13) angesteuert. Über den Transistor (5) wird eine Last (4), hier ein Magnetventil, versorgt.

Der Leistungstransistor (5) ist überbrückt durch eine Serienschaltung eines Widerstandes (6) und eines Umschalters (10). Der eine Pol des Widerstandes (6) liegt am Knotenpunkt (9) zwischen dem Transistor (5) und der Last (4). Mit Hilfe des Umschalters (10), der vorzugsweise als elektronischer Schalter (Gegentakt-Endstufe) ausgebildet ist, kann der andere Pol des Widerstandes (6) wahlweise an den Emitter des Transistors (5) oder an Masse angeschlossen werden. Zur Umschaltung dient eine vom Mikrocomputer (2) kommende Steuerleitung (14).

Der Zustand des Knotenpunktes (9) zwischen dem Leistungstransistor (5) und der Last (4) wird durch eine Überwachungsschaltung, hier durch den Mikrocomputer (2), über eine Leitung (12) überwacht.

Die erfindungsgemäße Schaltung nach der Fig.2 funktioniert wie folgt.

In jedem Regelzyklus des Blockierschutzprogramms oder in bestimmten Zeitabständen wird ein Testprogramm mit drei Schritten durchgeführt.

Als erstes wird der Transistor (5) bzw. die Endstufe (3) kurzzeitig eingeschaltet. Dabei ist die Einschaltdauer in bekannter Weise so knapp bemessen, daß die Last bzw. das Magnetventil (4) nicht anspricht.

Als zweiten Schritt steuert der Mikrocomputer (2) den Umschalter (10) in die linke Schaltstellung, d.h. an dem Emitter des Transistors (5). Dies ist die Normalstellung des Umschalters (10). Hierdurch wird der Kollektor des Transistors (5) über den Widerstand (6) mit der Batteriespannung (U_{B}) bzw. dem Emitter verbunden und somit spannungsmäßig hochgezogen (pull up). Das Potential des Kollektor, d.h. die Spannung des Punktes (9) wird dabei vom Mikrocomputer (2) abgetastet.

Als dritter Schritt wird der Umschalter (10) in die rechte Schaltstellung geschaltet und damit der Punkt (9) über den Widerstand (6) mit Masse verbunden (pull down). Damit ist der Testzyklus beendet, und der Umschalter (10) wird wieder zurückgesteuert.

Anstelle der Abtastung über dem Mikrocomputer (2) kann der Punkt (9) auch über einen anderen Mikrocomputer oder eine separate Überwachungseinrichtung bzw. Steuerschaltung abgetastet werden. Diese verknüpft das Signal auf der Leitung (13) mit dem Signal auf der Überwachungsleitung (12).

Der beschriebene Testzyklus wird auch durchgeführt während eine Blockierschutz-(ABS-)Regelung läuft. In den Zeitphasen, in denen der Endtransistor (5) während der ABS-Regelung gerade leitend ist, wird hierzu der Transistor (5) kurzzeitig abgeschaltet. Die Abschaltung dauert ca. 100 µs, was so kurzzeitig ist, daß der Zustand des Magnetventils (4) dadurch nicht verändert wird. Die Abschaltspannung am Transistor (5) wird dabei auf etwa -30 Volt begrenzt. Anschließend wird die bereits oben beschriebene Umschaltung des Schalters (10) und die gleichzeitige Spannungsüberwachung des Punktes (9) durch den Mikrocomputer (2) ausgeführt.

Anstelle einer zyklischen Umschaltung kann natürlich auch ein einmaliger Test, z. B. beim Einschalten der Elektronik, durchgeführt werden.

Durch die erfindungsgemäße Testschaltung nach der Fig.2 ist es möglich, den kritischen Fehlerfall "Kurzschluß des Transistors 5" zu unterscheiden von dem anderen, unkritischen Fehlerfall "Unterbrechung der Verbindungsleitung zur Last (4) bzw. Unterbrechung innerhalb der Last (4)". In beiden diesen Fällen hat der Punkt (9) nämlich normalerweise, d.h. ohne die Testschaltung das Potential (+U_{B}).

Der Widerstand (6) ist über den Umschalter (10) an den Emitter des Transistors (5) geschaltet. Dadurch fließt ein im Vergleich zum Erregungsstrom des Magnetventiles (4) sehr kleiner Meßstrom durch die Last (4). Der Wert des Widerstandes (6) liegt bei ca. 5 bis 15 kΩ während der Widerstand der Last (4) bei ca. 15 Ω liegt.

Trotz des Meßstromes erkennt die Überwachungsschaltung (Mikrocomputer (2)) auf gesperrten Transistor (5). Bei einer Unterbrechung der Last wird die Spannung am Knotenpunkt (9) hochgezogen, was für die Überwachungsschaltung zunächst wie ein durchgeschalteter Transistor (5) aussieht.

Zur Unterscheidung zwischen dem kritischen und dem unkritischen Fall wird der Umschalter (10) nun so gesteuert, daß der Widerstand (6) an Masse geschaltet wird und das Signal auf der Leitung (12) erneut bewertet wird. Die Überwachungsschaltung erkennt auf Kabelbruch, wenn die Spannung am Knotenpunkt (9) dadurch runtergezogen wurde, bzw. auf fehlerhaften Transistor, wenn die Spannung unverändert hoch ist.

Durch die erfindungsgemäße Schaltung wird in der rechten Stellung des Umschalters (10) (pull down) das Potential des Punktes (9) im beschriebenen Fehlerfall bei gesperrtem Transistor (5) auf Null herabgezogen. Falls dies möglich ist, erkennt hieraus der Mikrocomputer (2), daß der Transistor (5) keinen Kurzschluß aufweisen kann.

Bei einer Unterbrechung in der Verbindungsleitung oder der Last (4) wird in der linken Stellung des Umschalters (10) das Potential des Punktes (9) auf die Batteriespannung (U_{B}) heraufgezogen (pull up). Hieraus erkennt der Mikrocomputer (2), daß die Last (4) bzw. die Verbindungsleitung (9) eine Unterbrechung haben müssen, da ein Heraufziehen sonst nicht möglich wäre.

Die Fig.3 zeigt eine Variante der Fig.2. Der Widerstand (6) aus der Fig.2 ist hier sinngemäß aufgeteilt in zwei Serienwiderstände (7, 8). von je ca. 5 kΩ. Am Verbindungspunkt der Widerstände (7, 8) ist ein elektronischer Schalter (11) angeschlossen, mit dem dieser Punkt wahlweise an Masse gelegt werden kann. Der Schalter (11) wird wiederum vom Mikrocomputer (2) über die Leitung (14) gesteuert und ist vorzugsweise ebenfalls als Transistorschalter ausgebildet.

Der Vorteil der Schaltung nach der Fig.3 liegt darin, daß anstelle eines Umschalters wie in Fig.2 hier lediglich ein Ein-/Ausschalter (11) ausreichend ist.

Ein Kurzschluß des Transistors (5) wird vom Mikrocomputer (2) dann erkannt, wenn bei gesperrter Steuerleitung (13) bzw. gesperrtem Transistor (9) der Punkt (9) trotzdem High-Potential aufweist, und sich das Potential bei anschließendem Einschalten des elektronischen Schalters (11) nicht ändert.

Eine fehlende Last (4) wird dann erkannt, wenn der Punkt (9) bei gesperrtem (intaktem) Transistor (5) ein High-Potential aufweist, und nach anschließendem Einschalten des elektronischen Schalters (11) das Potential auf Null bzw. Low wechselt.

In den Schaltungen nach den Fig.1 bis 3 kann in bekannter Weise die Masse mit (-U_{B}) verbunden sein. Es kann aber auch eine gesonderte Masse gebildet sein, die potentialmäßig zwischen (+U_{B}) und (-U_{B}) liegt. An der grundsätzlichen Funktion der Schaltung ändert sich dadurch nichts.

Der Mikrocomputer (2) bzw. die gesonderte Steuerschaltung kann vorzugsweise auch die Funktion des elektronischen Schalters (10, 11) mit überprüfen. Hierzu ist der Ausgang des Schalters (10, 11) über eine Leitung (15) an den Mikrocomputer (2) zurückgeführt. Diese prüft dann, ob eine zeitliche und logische Übereinstimmung mit dem Ansteuersignal der Leitung (14) besteht.

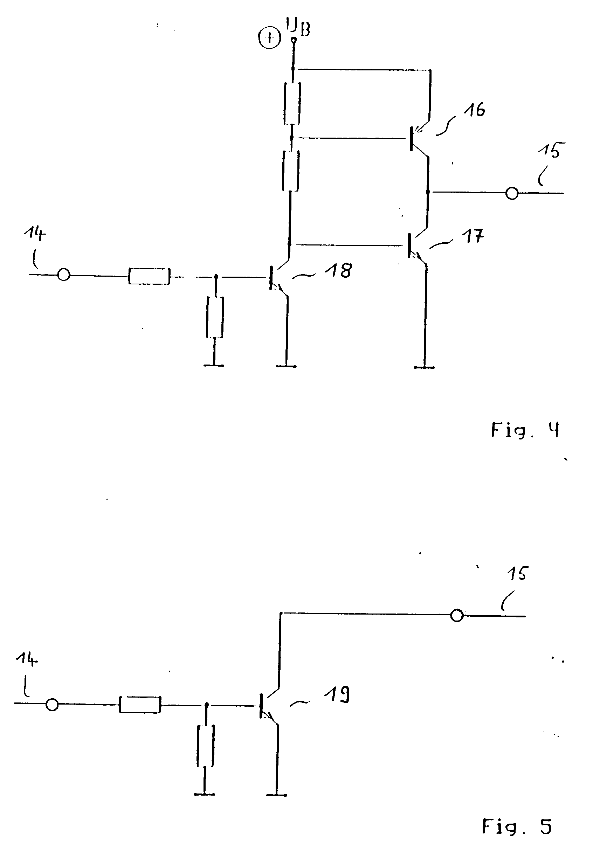

Die Fig.4 zeigt den inneren Aufbau des elektronischen Umschalters (10).

Falls über die Steuerleitung (14) ein High-Signal ansteht, leitet der Transistor (18). Hierdurch wird die Basis des Transistors (16) potentialmäßig herabgezogen, und dieser leitet die Batteriespannung (U_{B}) an die Ausgangsleitung (15) weiter. Der Transistor (17) sperrt, da dessen Basis an Masse liegt.

Falls an der Steuerleitung (14) ein Low-Signal steht, wechseln alle Transistoren (16 - 18) ihren Zustand, und die Ausgangsleitung (15) ist über den Transistor (17) mit Masse verbunden.

Die Fig. 5 zeigt den inneren Aufbau des elektronischen Schalters (11).

Falls der Eingangsleitung (14) ein High-Signal ansteht, leitet der Transistor (19) und verbindet die Ausgangsleitung (15) mit Masse.

## Patentansprüche

1. Elektronische Schaltung zur Überwachung eines Endverstärkers (3) und/oder seiner Last (4), insbesondere in einem Antiblockiersystem für Fahrzeuge, mit mindestens einem Mikrocomputer (2) zur Erzeugung von Steuersignalen für die Last (4 Magnetventil MV), und mit einem zwischen den Mikrocomputer (2) und die Last (4) geschalteten Endverstärker (3), gekennzeichnet durch folgende Merkmale:
a) parallel zum Endtransistor (5) des Endverstärkers (3) ist eine Widerstandsschaltung (6, 7, 8) vorgesehen;
b) ein Anschluß der Widerstandsschaltung (6, 7, 8) ist mittels eines elektronischen Schalters (10, 11) durch den Mikrocomputer (2) oder eine gesonderte Steuerschaltung an Masse schaltbar;
c) der Mikrocomputer (2) oder die gesonderte Steuerschaltung tastet die Spannung am Verbindungspunkt (9) von Endtransistor (5) und Last (4) ab und prüft die Spannung auf richtige Höhe.

2. Schaltung nach Anspruch 1, gekennzeichnet durch folgende Merkmale:
a) ein Anschluß der Widerstandsschaltung (6) ist durch einen elektronischen Umschalter (10) wahlweise mit der Versorgungsspannung (U_{B}) oder mit Masse verbindbar;
b) der Mikrocomputer (2) oder die gesonderte Steuerschaltung steuert den Umschalter (10) in festgelegten Zeitpunkten um. (Fig.2)

3. Schaltung nach Anspruch 1, gekennzeichnet durch folgende Merkmale:
a) die Widerstandsschaltung besteht aus zwei in Reihe liegenden Widerständen (7, 8), an deren Verbindungspunkt der elektronische Schalter (11) angeschlossen ist, durch welchen dieser Punkt an Masse gelegt werden kann;
b) der Mikrocomputer (2) oder die gesonderte Steuerschaltung steuert den Schalter (11) in festgelegten Zeitpunkten an. (Fig.3)

4. Schaltung nach Anspruch 1 bis 3, dadurch gekennzeichnet, daß die Schalter (10, 11) als Transistorschalter (Gegentaktendstufe) ausgebildet sind.

5. Schaltung nach Anspruch 1 bis 4, gekennzeichnet durch die folgenden Merkmale:
a) das Ausgangssignal des elektronischen Schalters (10, 11) wird über eine Leitung (15) zum Mikrocomputer (2) oder zu der gesonderten Steuerschaltung geführt;
b) der Mikrocomputer (2) oder die gesonderte Steuerschaltung prüft das Ansteuersignal auf der Leitung (14) mit dem Ausgangssignal auf der Leitung (15) auf logische Übereinstimmung.

## Claims

1. An electronic circuit for monitoring an output amplifier (3) and/or its load (4), in particular in an anti-lock system for vehicles, having at least one microcomputer (2) for generating control signals for the load (4 electromagnetic valve MV), and having an output amplifier (3) connected between the microcomputer (2) and the load (4), characterized by the following features:
a) a resistance circuit (6, 7, 8) is provided parallel to the output transistor (5) of the output amplifier (3);
b) a connection of the resistance circuit (6, 7, 8) is arranged to be connected to earth by means of an electronic switch (10, 11) by the microcomputer (2) or a separate control circuit;
c) the microcomputer (2) or the separate control circuit detects the voltage at the connection point (9) of the output transistor (5) to the load (4) and checks that the voltage is at the correct level.

2. A circuit according to Claim 1, characterized by the following features:
a) a connection of the resistance circuit (6) is arranged to be connected by an electronic changeover switch (10) selectively to the supply voltage (U_{B}) or to earth;
b) the microcomputer (2) or the separate control circuit changes over the changeover switch (10) at fixed intervals (Fig. 2).

3. A circuit according to Claim 1, characterized by the following features:
a) the resistance circuit consists of two series-connected resistors (7, 8), to the junction point of which is connected the electronic switch (11) by which this point can be earthed;
b) the microcomputer (2) or the separate control circuit changes over the switch (11) at fixed intervals (Fig. 3).

4. A circuit according to Claims 1 to 3, characterized in that the switches (10, 11) are in the form of transistor switches (push-pull output stage).

5. A circuit according to Claims 1 to 4, characterized by the following features:
a) the output signal of the electronic switch (10, 11) is supplied by way of a line (15) to the microcomputer (2) or to the separate control circuit;
b) the microcomputer (2) or the separate control circuit checks the control signal on the line (14) against the output signal on line (15) for logic-level consistency.

## Revendications

1. Circuit électronique pour surveiller un amplificateur final et/ou sa charge, notamment dans un système antiblocage pour véhicules automobiles, comportant : au moins un microcalculateur (2) pour produire des signaux de commande pour la charge (4, électrovanne MV), et un amplificateur final (3) branché entre le microcalculateur (2) et la charge (4),caractérisé par les caractéristiques suivantes :
a) un circuit résistant (6, 7, 8) est prévu en parallèle du transistor de sortie (5) de l'amplicateur final (3);
b) le microcalculateur (2), ou un circuit de commande particulier, peut provoquer la mise à la masse du circuit résistant (6, 7, 8) au moyen d'un commutateur ou interrupteur électronique (10, 11);
c) le microcalculateur (2) ou le circuit de commande particulier lit la tension aux point (9) de jonction du transistor final à la charge (4), et vérifie que la tension est à un niveau correct.

2. Circuit selon revendication 1, caractérisé par les caratéristiques suivantes :
a) une borne du circuit résistant (6) peut être sélectivement reliée, par un commutateur électronique (10), soit à la tension d'alimentation (U_{B}), soit à la masse;
b) le microcalculateur (2), ou le circuit de commande particulier, commande le commutateur (10) pour qu'il commute à des instants fixés.(figure 2)

3. Circuit selon revendication 1, caractérisé par les caractéristiques suivantes :
a) le circuit résistant est constitué par deux résistances (7, 8) montées en série, au point de jonction desquelles est raccordé l'interrupteur électronique (11) par lequel ce point peut être mis à la masse;
b) le microcalculateur (2), ou le circuit de commande particulier, commande l'interrupteur (11) à des instants fixés. (figure 3)

4. Circuit selon revendications 1 à 3, caractérisé par le fait que les commutateurs et/ou interrupteurs (11) sont réalisés en tant que commutateur ou interrupteur transistorisé (étage final symétrique).

5. circuit selon revendications 1 à 4, caractérisé par les caractéristiques suivantes :
a) le signal de sortie du commutateur ou interrupteur électronique (10, 11) est amené, par une ligne (15), au microcalculateur (2) ou au circuit de commande particulier;
b) le microcalculateur (2), ou le circuit de commande particulier, vérifie l'accord logique entre le signal de commande sur la ligne (14) et le signal de sortie sur la ligne (15).
